(19) Europäisches Patentamt
European Patent Office
Office européen des brevets

(11) Veröffentlichungsnummer: **0 025 506**
**B1**

(12) # EUROPÄISCHE PATENTSCHRIFT

(45) Veröffentlichungstag der Patentschrift: **25.05.83**

(51) Int. Cl.³: **C 08 G 73/22,** C 08 G 73/06, G 03 C 1/70, G 03 F 7/08

(21) Anmeldenummer: **80104643.4**

(22) Anmeldetag: **06.08.80**

(54) **Polyoxazol-Vorstufen, deren Herstellung und Verwendung.**

(30) Priorität: **21.08.79 DE 2933828**

(43) Veröffentlichungstag der Anmeldung: **25.03.81 Patentblatt 81/12**

(45) Bekanntmachung des Hinweises auf die Patenterteilung: **25.05.83 Patentblatt 83/21**

(84) Benannte Vertragsstaaten: **AT BE CH DE FR GB IT LI NL SE**

(56) Entgegenhaltungen:
**DE-A-1 595 723**
**DE-B-2 308 830**
**DE-B-2 437 348**
**GB-A-1 100 827**
**US-A-3 483 105**
**ENCYCLOPEDIA OF POLYMER SCIENCE AND TECHNOLOGY; Band 7, 1967, INTERSCIENCE, New York Seiten 494, 495**

(73) Patentinhaber: **SIEMENS AKTIENGESELLSCHAFT, Berlin und München Wittelsbacherplatz 2, D-8000 München 2 (DE)**

(72) Erfinder: **Ahne, Hellmut, Dr., Heidestrasse 6, D-8551 Röttenbach (DE)**
Erfinder: **Kühn, Eberhard, Bergstrasse 32, D-8551 Hemhofen (DE)**
Erfinder: **Rubner, Roland, Dr., Buchenring 15, D-8551 Röttenbach (DE)**

**EP 0 025 506 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Polyoxazol-Vorstufen, deren Herstellung und Verwendung

Die Erfindung betrifft oligomere und/oder polymere Vorstufen von Polyoxazolen sowie ein Verfahren zur Herstellung dieser Vorstufen.

Vorstufen von Polymeren sind beispielsweise aus der deutschen Patentschrift 2 308 830 bzw. der entsprechenden US-Patentschrift 3 957 512 bekannt. Diese Polymer-Vorstufen sind Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carbonyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen und die mit diesen Verbindungen umzusetzenden Diamine, Diisocyanate, Bis-säurechloride und Dicarbonsäuren weisen mindestens ein cyclisches Strukturelement auf.

Die bekannten Polymer-Vorstufen dienen zur Herstellung von Schutz- und Isolierschichten sowie von Reliefstrukturen aus hochwärmebeständigen Polymeren, in die sie durch Belichtung und gegebenenfalls durch nachfolgendes Tempern übergeführt werden. Dabei werden insbesondere Polymere folgender Stoffklassen erhalten: Polyimide, Polyamidimide, Polyesterimide, Poly-1,3-chinazolin-2.6-dione, Polyisoindolochinazolindione, Poly-1.3-oxazin-6-one und Polybenz-1.3-oxazin-2.4-dione.

Aufgabe der Erfindung ist es, neue Polymer-Vorstufen bereitzustellen, die die Palette von Ausgangsstoffen zur Herstellung von Reliefstrukturen sowie von Schutz- und Isolierschichten verbreitern. Insbesondere sollen strahlungsreaktive Polyoxazol-Vorstufen geschaffen werden.

Dies wird erfindungsgemäß dadurch erreicht, daß die Vorstufen aus Additionsprodukten von olefinisch ungesättigten Monoepoxiden an hydroxylgruppenhaltige Polykondensationsprodukte von aromatischen und/oder heterocyclischen Dihydroxydiaminoverbindungen mit Dicarbonsäurechloriden oder -estern bestehen.

Strahlungsreaktive Polyoxazol-Vorstufen sind bislang noch nicht bekannt. Die erfindungsgemäßen Verbindungen weisen diese Eigenschaft auf; sie können daher durch Strahlung vernetzt und dabei in hochwärmebeständige Polymere mit ausgezeichneten Eigenschaften übergeführt werden (vgl. dazu die gleichzeitig eingereichte europäische Patentanmeldung »Verfahren zur Herstellung hochwärmebeständiger Reliefstrukturen und deren Verwendung«, EP-A1 0 026 821). Neben der Photostrukturierbarkeit zeichnen sich die erfindungsgemäßen Verbindungen auch noch durch eine gute Löslichkeit in organischen Lösungsmitteln aus.

Die erfindungsgemäßen Polyoxazol-Vorstufen weisen im allgemeinen folgende Struktur (1) oder (2) auf:

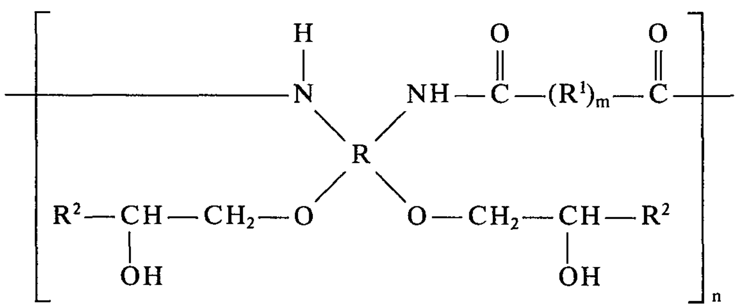

(1)

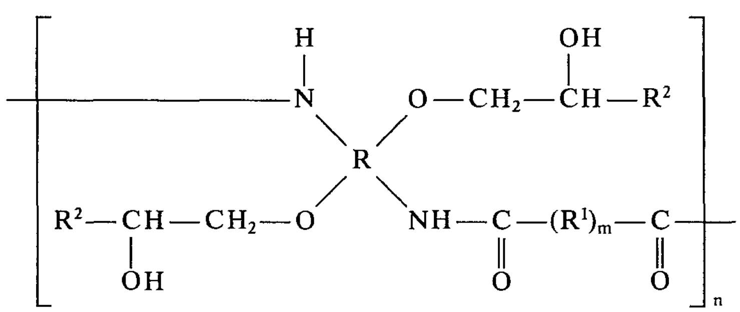

(2)

In den Formeln (1) und (2) bedeutet n eine ganze Zahl von 2 bis etwa 100 und m = 0 oder 1.

Für R, $R^1$ und $R^2$ gilt folgendes:

R ist ein — gegebenenfalls halogenierter — zumindest partiell aromatischer und/oder heterocyclischer tetravalenter, d. h. tetrafunktioneller Rest, bei dem jeweils zwei Valenzen in Nachbarstellung zueinander angeordnet sind; weist der Rest R mehrere aromatische und/oder heterocyclische Strukturelemente auf, so befinden sich die Valenzpaare jeweils an endständigen derartigen Strukturelementen;

$R^1$ ist ein — gegebenenfalls halogenierter — divalenter, d. h. difunktioneller Rest aliphatischer und/oder cycloaliphatischer, gegebenenfalls Heteroatome aufweisender, und/oder aromatischer und/oder heterocyclischer Struktur;

$R^2$ ist ein olefinisch ungesättigter Rest, insbesondere eine — gegebenenfalls substituierte — (meth)acrylesterhaltige Gruppe.

Die Reste R, $R^1$ und $R^2$ haben insbesondere folgende Bedeutung:

R =

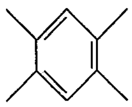
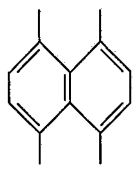
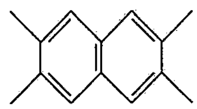
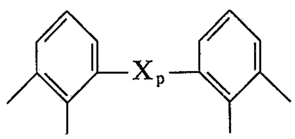
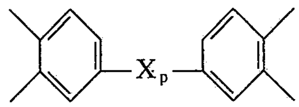
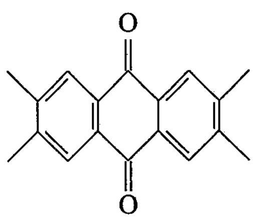
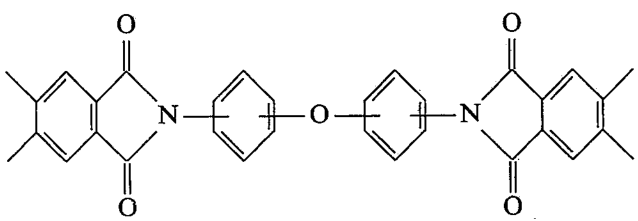
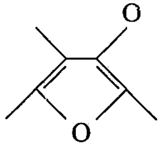
und
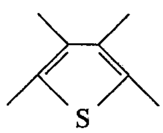

wobei p = 0 oder 1 ist und X für einen der folgenden Reste steht,

X =

—O—
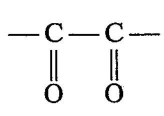
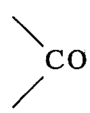
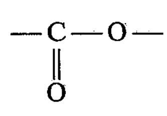
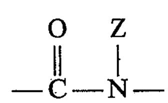
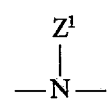
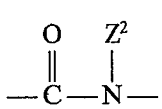
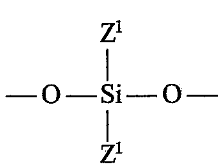
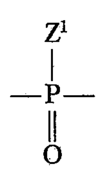
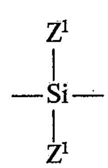
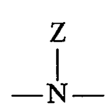

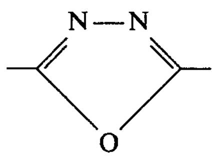 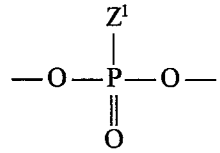 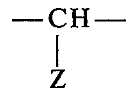 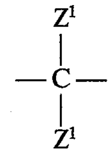

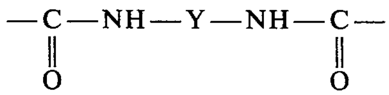 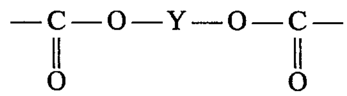 $—SO—$

$—SO_2—$ $—SO_2NH—$ $—S—$ 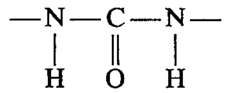 $—N{=}N—$

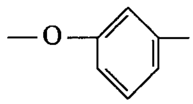 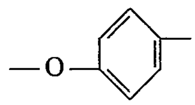 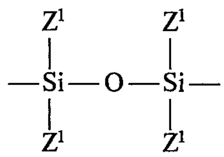 und 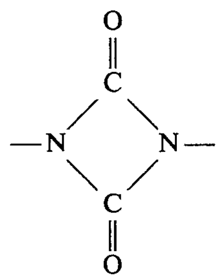

Für die weiteren Reste gilt:

Y =

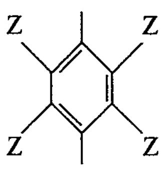 $—(CH_2)_o—$ mit o = 2 bis 10,

und

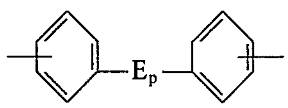 mit p = 0 oder 1,

Z = H oder Alkyl mit 1 bis 6 Kohlenstoffatomen,
$Z^1$ = Alkyl mit 1 bis 10 Kohlenstoffatomen oder Aryl,
$Z^2$ = Aryl oder Heteroaryl, und

E =

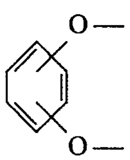 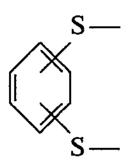 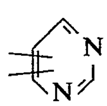 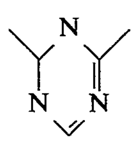 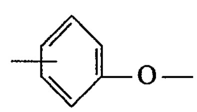 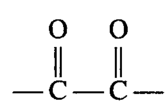

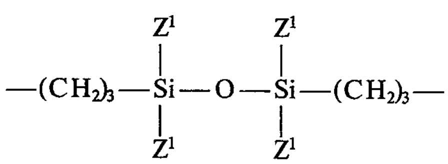 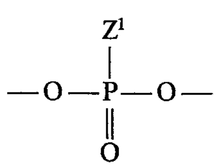 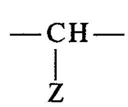

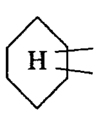 $—(CH_2)_q—$ $—(CF_2)_r—$ $—SO—$ $—SO_2—$

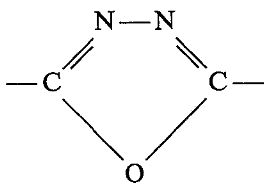 $-SO_2NH-$ 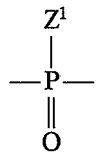 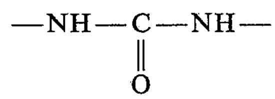 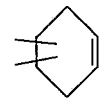

$-N{=}N-$ 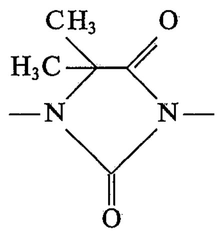 $-S-$ $-O-$ 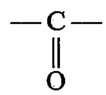 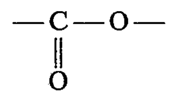

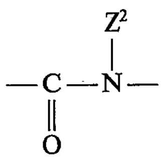 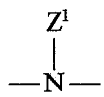 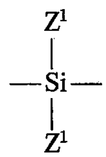 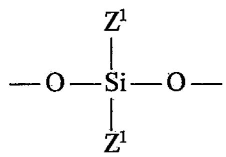 und 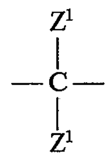

wobei q = 2 bis 14 und r = 2 bis 18, und $Z^1$ und $Z^2$ wie vorstehend definiert sind.

$R^1$ =

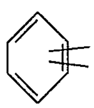 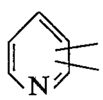 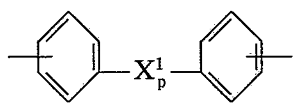 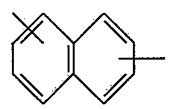 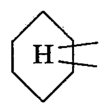

$-(CH_2)_q-$ $-(CF_2)_r-$ 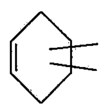 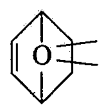 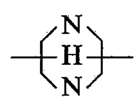

und

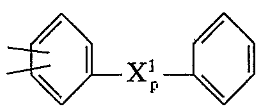

wobei p = 0 oder 1, q = 2 bis 14 und r = 2 bis 18.

$X^1$ =

$-O-$ 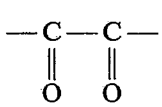 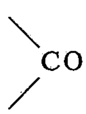 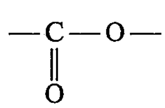 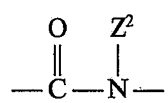 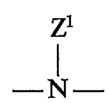

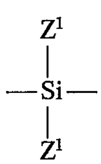 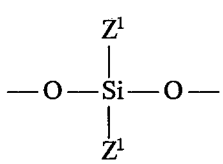 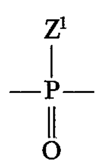 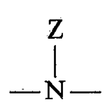 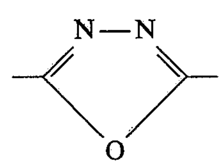

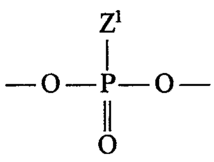 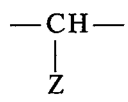 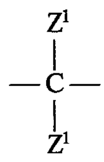 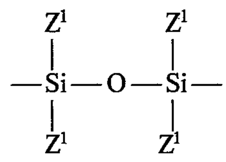 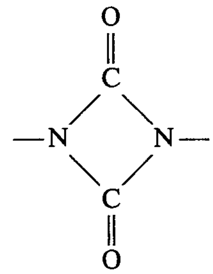

$-SO-$ $-SO_2-$ $-SO_2NH-$ $-S-$ 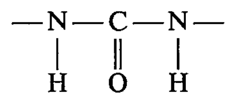

$-N{=}N-$ 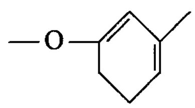 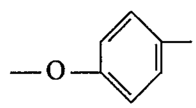

und

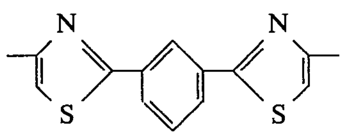

wobei Z, $Z^1$ und $Z^2$ wie vorstehend definiert sind.

$R^2$ =

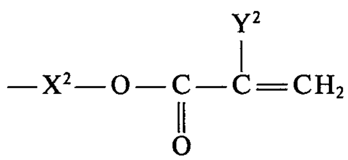

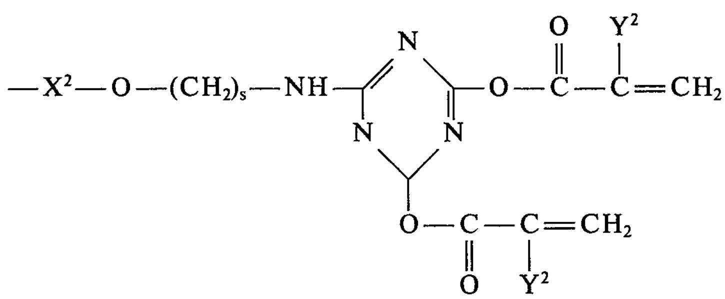

und

$-X^2-O-CH_2-CH{=}CH_2$

dabei ist s = 2 bis 16;
für die weiteren Reste gilt:

$X^2$ =

$-CH_2-$ und $-CH_2-O-[(CH_2)_r-O]_t-(CH_2)_s-$ und

$Y^2$ =

$-H$ $-CH_3$ $-Cl$ $-Br$ $-C{\equiv}N$

wobei r = 2 bis 18, s = 2 bis 16 und t = 0 bis 10.

Die erfindungsgemäßen polymeren Vorstufen sind Additionsprodukte von olefinisch ungesättigten Monoepoxiden an hydroxylgruppenhaltige Prepolymere. Diese Prepolymere wiederum sind Polykondensationsprodukte von Dihydroxydiaminoverbindungen und Dicarbonsäurechloriden oder -estern. Die bevorzugt eingesetzte Dihydroxydiaminoverbindung ist 3.3'-Dihydroxybenzidin, bei den Dicarbonsäurederivaten werden Isophthalsäuredichlorid und Benzophenondicarbonsäuredichlorid bevorzugt.

An die genannten hydroxylgruppenhaltigen Prepolymeren werden olefinisch ungesättigte Monoepoxide addiert. Diese Epoxide weisen folgende Struktur (3) auf, wobei der ungesättigte Rest $R^2$ die vorstehend angegebene Bedeutung besitzt:

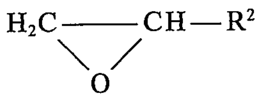

(3)

Bevorzugt werden die ungesättigten Epoxide Glycidylacrylat und -methacrylat.

Anhand der nachfolgenden Formel (4) wird die Struktur der erfindungsgemäßen Polyoxazol-Vorstufen beispielhaft verdeutlicht:

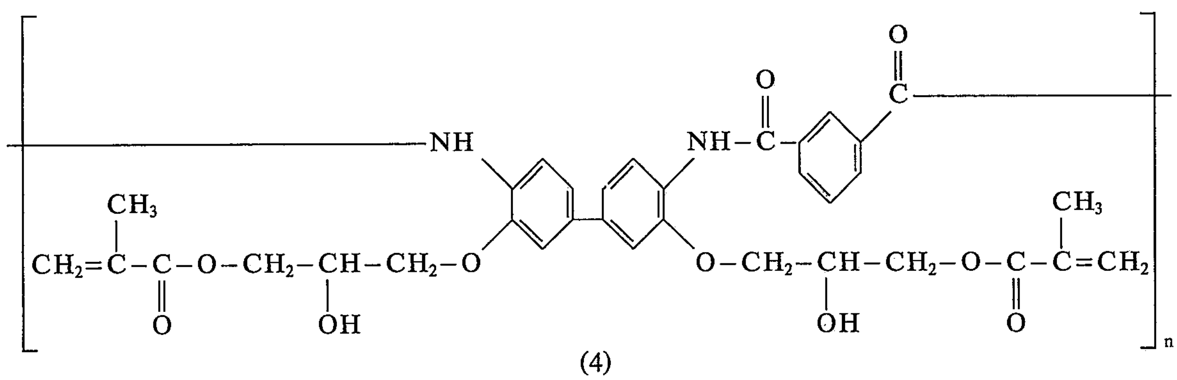

(4)

In der Formel (4) ist das Additionsprodukt von Glycidylmethacrylat an das Polykondensationsprodukt von 3.3'-Dihydroxybenzidin und Isophthalsäuredichlorid dargestellt.

Die erfindungsgemäßen Vorstufen weisen als Grundbaustein bevorzugt aromatische Dihydroxydiaminoverbindungen auf und ergeben somit bei der thermischen Behandlung Polymere mit folgender Struktureinheit (5):

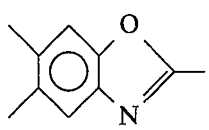

(5)

Polyoxazol

Die erfindungsgemäßen Polyoxazol-Vorstufen werden vorteilhaft in der Weise hergestellt, daß eine aromatische und/oder heterocyclische Dihydroxydiaminoverbindung mit einem Dicarbonsäurechlorid oder -ester zu einem hydroxylgruppenhaltigen Polykondensationsprodukt umgesetzt wird und daß Polykondensationsprodukt bei Raumtemperatur oder bei Temperaturen bis ca. 100°C in einem organischen Lösungsmittel, gegebenenfalls in Gegenwart eines aminischen Katalysators, mit einem olefinisch ungesättigten Monoepoxid zur Reaktion gebracht wird.

Dieses Verfahren weist den Vorteil auf, daß es präparativ einfach durchzuführen ist, und es verläuft bei relativ niedrigen Temperaturen, d. h. bei Temperaturen, bei denen noch keine Umwandlung der Vorstufen in unlösliche Cyclisierungsprodukte erfolgt. Die Reaktionsprodukte fallen darüber hinaus in reinem Zustand an.

Außer zur Verwendung als Photoresist und zur Herstellung von Schutz- und Isolierschichten, wobei eine Strukturierung erfolgt, können die erfindungsgemäßen Vorstufen auch allgemein — in nicht strukturierter Form — zur Herstellung von Schutz- und Isolierüberzügen dienen. Besonders vorteilhaft können diese Vorstufen dabei zur Herstellung von Kunststoffüberzügen für die Lichtleitfasern von Lichtwellenleitern verwendet werden.

Anhand von Ausführungsbeispielen, in denen die Darstellung von strahlungsreaktiven Polybenzoxazol-Vorstufen beschrieben ist, soll die Erfindung noch näher erläutert werden.

Beispiel 1

Zu einer Lösung von 6,49 Gewichtsteilen 3.3'-Dihydroxybenzidin in 50 Volumenteilen Dimethylacetamid und 9 Volumenteilen Pyridin werden unter intensivem Rühren bei einer Temperatur von −5 bis −20°C innerhalb von etwa 30 Minuten 6,1 Gewichtsteile Isophthalsäuredichlorid in 20 Volumenteilen Cyclohexanon getropft. Nach 3stündigem weiteren Rühren bei Raumtemperatur wird die viskose Reaktionslösung über Nacht stehengelassen, dann wird die Lösung unter Rühren in 1000 Volumenteile Wasser getropft. Das sich dabei abscheidende Harz wird abgetrennt, mit Wasser und Methanol gewaschen und im Vakuum bei ca. 60°C getrocknet.

10 Gewichtsteile des auf die beschriebene Weise hergestellten Polybenzoxazol-Prepolymeren werden in 100 Volumenteilen n-Methylpyrrolidon gelöst. Zu dieser Lösung werden 50 Volumenteile Glycidylmethacrylat, 0,5 Volumenteile Benzyldimethylamin und 0,5 Gewichtsteile Hydrochinon gegeben. Nach 2stündigem Erwärmen auf eine Tempeatur von ca. 90°C wird das Reaktionsprodukt unter Rühren aus 1000 Volumenteilen Äthanol gefällt. Nach dem Trocknen im Vakuum wird ein gelbbraunes Pulver erhalten, das — im Gegensatz zum Prepolymeren — in wäßrigalkalischer Lösung nicht mehr löslich ist. Dies ist ein deutliches Indiz dafür, daß ein ausreichend hoher Anteil an phenolischen Hydroxylgruppen mit dem ungesättigten Epoxid veräthert worden ist. Das IR-Spektrum (Film) der Polybenzoxazol-Vorstufe zeigt die für die Methacrylatgruppierung typischen Banden bei 950 und 1290 $cm^{-1}$.

Diese Banden fehlen im Spektrum des nicht photoreaktiven Prepolymeren.

Beispiel 2

Entsprechend Beispiel 1 wird ein nicht strahlungsreaktives Prepolymeres hergestellt, wobei aber anstelle von Isophthalsäuredichlorid 4.4'-Benzophenondicarbonsäuredichlorid (9,4 Gewichtsteile in 30 Volumenteilen Cyclohexanon) verwendet wird. Ohne das Prepolymere auszufällen, werden zur dabei erhaltenen Reaktionslösung 40 Volumenteile Glycidylacrylat, 1 Volumenteil Benzyldimethylamin und 0,5 Gewichtsteile Hydrochinon gegeben. Nach 12stündigem Rühren und Erwärmen auf ca. 65°C wird das Reaktionsprodukt aus 500 Volumenteilen Äthanol gefällt. Nach dem Trocknen wird ein gelbbraunes Pulver erhalten, das in wäßrig-alkalischer Lösung nicht mehr löslich ist. Das IR-Spektrum (Film) zeigt bei 815 und 990 $cm^{-1}$ Absorptionsbanden, die der Acrylatgruppierung zuzuordnen sind.

**Patentansprüche**

1. Oligomere und/oder polymere Vorstufen von Polyoxazolen, dadurch gekennzeichnet, daß sie aus Additionsprodukten von olefinisch ungesättigten Monoepoxiden an hydroxylgruppenhaltige Polykondensationsprodukte von aromatischen und/oder heterocyclischen Dihydroxydiaminoverbindungen mit Dicarbonsäurechloriden oder -estern bestehen.

2. Polyoxazol-Vorstufen nach Anspruch 1, dadurch gekennzeichnet, daß das ungesättigte Monoepoxid Glycidylacrylat oder -methacrylat ist.

3. Polyoxazol-Vorstufen nach Anspruch 1 oder 2, gekennzeichnet durch ein Polykondensationsprodukt aus 3.3'-Dihydroxybenzidin und Isophthalsäuredichlorid oder Benzophenondicarbonsäuredichlorid.

4. Verfahren zur Herstellung von Polyoxazol-Vorstufen nach einem der Ansprüche 1 bis 3, dadurch gekennzeichnet, daß eine aromatische und/oder heterocyclische Dihydroxydiaminoverbindung mit einem Dicarbonsäurechlorid oder -ester zu einem hydroxylgruppenhaltigen Polykondensationsprodukt umgesetzt wird und daß das Polykondensationsprodukt bei Raumtemperatur oder bei Temperaturen bis ca. 100°C in einem organischen Lösungsmittel, gegebenenfalls in Gegenwart eines aminischen Katalysators, mit einem olefinsich ungesättigten Monoepoxid zur Reaktion gebracht wird.

5. Verwendung der Polyoxazol-Vorstufen nach einem der Ansprüche 1 bis 3 zur Herstellung von Kunststoffüberzügen für die Lichtleitfasern von Lichtwellenleitern.

**Claims**

1. Oligomeric and/or polymeric precursors of polyoxazoles characterised in that they consist of addition products of olefinically-unsaturated monoepoxides with hydroxyl group-containing polycondensation products of aromatic and/or heterocyclic dihydroxydiamino compounds with dicarboxylic acid chlorides or dicarboxylic acid esters.

2. Polyoxazole precursors as claimed in Claim 1, characterised in that the unsaturated mono-epoxide is glycidyl acrylate or glycidyl methacrylate.

3. Polyoxazole precursors as claimed in Claim 1 or Claim 2, characterised by a polycondensation product of 3.3'-dihydroxybenzidine and isophthalic acid dichloride, or benzophenone-dicarboxylic

acid dichloride.

4. A process for the production of polyoxazole precursors as claimed in one of Claims 1 to 3, characterised in that an aromatic and/or heterocyclic dihydroxydiamino compound is reacted with a dicarboxylic acid chloride or dicarboxylic acid ester into a hydroxyl group-containing polycondensation product; and that the polycondensation product is reacted with an olefinically-unsaturated mono-epoxide at room temperature or at temperatures of up to about 100°C in an organic solvent, if necessary in the presence of an amine catalyst.

5. The use of the polyoxazole precursors as claimed in one of Claims 1 to 3 for the production of plastics coatings for the light-conducting fibres of light waveguides.

## Revendication

1. Précurseurs oligomèreset/ou polymères de polyoxazoles, caractérisés en ce qu'ils sont constitués de produits d'addition de monoépoxydes à insaturation oléfinique sur des produits de polycondensation contenant des groupes hydroxy, de composés dihydroxydiamino aromatiques et/ou hétérocyclique et de chlorures d'acide dicarboxylique ou d'esters d'acide dicarboxylique.

2. Précurseurs de polyoxazole suivant la revendication 1, caractérisés en ce que le monoépoxyde insaturé et l'acrylate de glycidyle ou le méthacrylate de glycidyle.

3. Précurseurs de polyoxazole suivant la revendication 1 ou 2, caractérisés par un produit de polycondensation constitué de 3,3'-dihydroxybenzidine et de dichlorure d'acide isophthalique ou de dichlorure d'acide benzophénone dicarboxylique.

4. Procédé de préparation de précurseurs de polyoxazole suivant l'une des revendications 1 à 3, caractérisé en ce qu'il consiste à faire réagir un composé dihydroxydiamino araomatique et/ou hétérocyclique sur un chlorure d'acide dicarboxylique ou sur un ester d'acide dicarboxylique pour obtenir un produit de polycondensation contenant des groupes hydroxy et à mettre le produit de polycondensation à réagir sur un monoépoxyde à insaturation oléfinique à température ambiante ou à des températures allant jusqu'à 100°C environ dans un solvant organique, le cas échéant, en présence d'un catalyseur aminé.

5. Utilisation des précurseurs de polyoxazole suivant l'une des revendications 1 à 3 pour la fabrication de revêtements en matière plastique pour les fibres optiques de guides d'ondes lumineuses.